# EUROPEAN PATENT SPECIFICATION

(11) **EP 0 555 339 B1**
(45) Date of publication and mention of the grant of the patent: **29.12.1997**
(21) Application number: 91920101.2
(22) Date of filing: 16.10.1991
(51) Int. Cl.: C23C 14/34, H01J 37/34

(54) **MAGNETRON SPUTTER COATING METHOD AND APPARATUS WITH ROTATING MAGNET CATHODE**
VERFAHREN UND VORRICHTUNG ZUR SPUTTENBESCHICHTUNG MIT ROTIERENDER MAGNETISCHER KATHODE
PROCEDE DE REVETEMENT PAR PULVERISATION PAR MAGNETRON ET APPAREIL AVEC CATHODE A AIMANT ROTATIF

(30) Priority: 31.10.1990 US 606701; 13.12.1990 US 626987
(43) Date of publication of application: 18.08.1993
(73) Proprietor: MATERIALS RESEARCH CORPORATION, Orangeburg New York 10962 (US)
(72) Inventor: HURWITT, Steven, D., Park Ridge, NJ 07656 (US); HIERONYMI, Robert, Rock Cavern, NY 10962 (US); WAGNER, Israel, Monsey, NY 10962 (US)
(74) Representative: Findlay, Alice Rosemary
(86) International application number: US9107683
(87) International publication number: WO9207970

(56) References cited:
- EP-A- 0 211 412
- EP-A- 0 240 369
- EP-A- 0 334 347
- EP-A- 0 365 249
- PATENT ABSTRACTS OF JAPAN vol. 12, no. 410 (C-540)(3257) 28 October 1988 & JP,A,63 149 374

## Description

The present invention relates to sputter coating and more particularly to magnetron enhanced sputter coating processes and apparatus employing magnets which are movable with respect to a sputtering cathode target.

Sputter coating is a process carried out in a vacuum chamber which is filled with a generally chemically inert gas in which a substrate is coated with a material from a target of sputtering material subjected to a negative electrical potential with respect to the chamber wall or other anode. The potential gradient adjacent the target surface causes electrons to be emitted from the target which, on their way to the chamber anode which is usually formed in part by the grounded chamber wall, strike and ionize some of the inert gas. The positive ions formed are then attracted to the negative target which they strike, transferring momentum to the target material, and ejecting particles of the material from the target surface. The substrate to be coated, which is positioned in the chamber usually with its surface facing the target, receives some of the ejected particles which adhere to and coat the substrate surface.

With magnetron sputtering, a magnetic field is formed over the target surface, usually including magnetic field lines parallel to the target surface, and, in many applications, in the form of a closed magnetic tunnel. The magnetic field causes the electrons emitted to move in curved spiral paths which trap them in regions proximate the target surface enclosed by the field, thereby increasing the rate of electron collisions with gas atoms, which in turn increase the ionization of the gas and the efficiency of the sputtering process.

In European Patent Application Nos. 90304044.2 and 90304043.4, a sputter coating apparatus and method are disclosed in which a concave annular target is provided with concentric annular electromagnets which cause the formation of a pair of concentric plasma rings. The plasma rings are alternately energized by alternately supplying current to energize the magnet coils while the target power level is switched in synchronization with the switching of the current to the magnetic coils. This causes different rates of sputtering from inner and outer concentric regions of the target surface, with the sputtering from each region causing different distribution characteristics of the sputtered material deposited on the substrate or wafer being coated. Varying the relative parameters affecting the energization of the two target regions provides control of coating uniformity on the substrate surfaces, which is especially important on the differently facing surfaces of stepped semiconductor wafers. The aforereferenced patent application particularly describes effects on the coating caused by the target geometry and by the electrical parameters relating to the energization of the target and plasmas.

In magnetron sputter coating processes, the sputtering of materials from the sputtering target occurs most rapidly into regions of the target where the plasma trapped by the magnetic field is the most dense. This causes the proportionate consumption or erosion of the sputtering material from the target surface. The erosion of sputtering material from other portions of the sputtering target surface generally occurs at a rate which varies in proportion to the strength and/or duration of the plasma over that portion of the target surface.

In the prior art it has been proposed in certain applications to move the magnetic field in relation to the sputtering target surface either by movement of the target or movement of the magnetic field. A purpose of the relative movement of the target or magnetic field with respect to each other is, in many cases, to provide a more uniform erosion or consumption of the sputtering target material over the surface of the target. Such devices have for many reasons been unsatisfactory.

In sputtering from a sputtering target while moving the target with respect to the magnetic field, a desirable erosion pattern is sometimes achieved for purposes of uniformly consuming the target material, but often such a pattern does not provide the proper or desired distribution of sputter coating material onto the surface of the substrate being coated. Furthermore, such devices of the prior art have insufficiently controlled the distribution of the plasma or the duration of the moving plasma with respect to the target surface so as to affect a desired non-uniform erosion pattern.

In addition, rotating magnet devices of the prior art have not effectively provided for the sputtering of the entire surface of the target. It has been found that the absence of at least some sputtering from any given region of the target may cause redeposition of the material sputtering from elsewhere on the target onto those regions where no sputtering is occurring. This causes a build-up of sputtering material which is undesirable.

Accordingly, there is a need to provide a method and apparatus for sputter coating substrates which employs a magnet which is movable relative to the sputtering target and which is capable of precisely controlling the distribution of sputtering on the target surface in its entirety.

When the magnet structure and target are rotated relative to each other, the prior art devices have failed to provide for sufficient sputtering from certain regions of the target surface, such as the center and edge regions of the target, and further have failed to effectively distribute the sputtering across the target surface in a manner which is effective to produce the desired erosion pattern to yield the proper coating uniformity on the substrate.

European Patent Application EP-A-0211412 describes a magnetron sputtering apparatus having a magnet which is rotated eccentrically around an axis of the target. The magnet is shaped or comprises a plurality of magnetic segments arranged so that the length of the plasma region along the direction of rotation of the magnet is proportional to the radius of the rotation. This gives a constant exposure for all regions across the target surface so leading to uniform erosion.

European Patent Application EP-A-0334347 describes a magnetron in which cooling fluid flows between the motor and the target back surface. The cooling fluid drives the motor to rotate it.

It is an objective of the present invention to provide a rotating magnet magnetron sputtering apparatus that avoids unsputtered areas of the target, and thus avoids a buildup by redeposition of sputtered material on the target.

It is another objective of the present invention to provide a rotating magnet sputtering target apparatus and method having a magnet structure which is configurable to produce a desired coating deposition on the substrate when the magnet structure is rotated during sputtering.

It is a further objective of the present invention to provide the rotating magnet structure in a sputter coating apparatus wherein the rotating magnet structure facilitates the circulation of cooling fluid for the sputtering cathode assembly.

A magnetron sputter coating apparatus for sputter coating a substrate in a pressure sealed chamber, in accordance with the invention, comprises a substrate holder, means for supporting a target of sputter coating material with the sputtering surface generally facing the substrate, a magnet carrier positioned behind the target opposite the substrate and mounted to rotate with respect to the target and substrate about an axis which intersects the target and substrate, means for rotating the carrier and a main magnet secured so as to rotate with the carrier and arranged in a closed loop, the main magnet producing a magnetic field which forms a closed magnetic tunnel trapping a plasma thereunder and which rotates over the sputtering surface of the target about the axis as the carrier rotates characterised in that auxiliary magnetic means distinct from the main magnet is provided near at least one section of the main magnet which reshapes the field of the magnet at the section and thereby modifies the position or strength of the plasma on the sputtering surface adjacent thereto, whereby to produce a desired sputtering distribution across the target surface.

The present invention also relates to a method of manufacturing a sputter coated article as set out in claim 15.

The magnet may comprise a continuous strip of magnetic material arranged to form the closed loop, the strip having an inner periphery of one polarity. A plurality of clamping blocks may be provided including at least one inner block mounted to the carrier adjacent at least a portion of the inner periphery of the strip and at least one outer block mounted to the carrier adjacent the outer periphery of the strip to clamp the strip therebetween, the blocks being so shaped and positioned on the carrier as to define the shape and position of the loop on the carrier and so configure the magnet with respect to the target as to produce a desired sputtering distribution across the target surface.

The sputter coating apparatus has a sputtering target included in a cathode assembly with a magnet located behind the sputtering target so as to produce a closed magnetic field over the target surface. The magnet is rotatably mounted so as to rotate the magnetic field over the surface of the sputtering target. The magnet in certain embodiments is configured with respect to the target to cause sputtering from the centre of the target to the outer rim of the target at a rate which varies with the radius from the centre in a desired manner.

In the preferred and illustrated embodiment of the present invention, the magnet is preferably a permanent magnet which includes a closed loop of magnetic material formed of a flexible magnetic strip. The strip has its poles spaced transversely across the strip, preferably generally in the plane in which the closed loop lies. The magnet, which is formed of flexible laminated strips of magnet impregnated plastic, is arranged on a rotating plate behind the sputtering target in a shape having a plurality of curves including a plurality of outwardly convex curves, some near the outer rim of the target, and at least one point at which the strip passes near, but not through, the target center. The magnet is shaped in such a way that the plasma trapped by the magnetic field will be present over various portions of the sputtering target at various radii from the center for predetermined amounts of time so as to provide a desired erosion pattern on the target surface.

According to the preferred embodiment of the present invention, the magnet is polarized in such a way that one pole faces the outer edge of the rotating plate while the other pole faces the axis of rotation so that, particularly at the outer edge, the field emerges from the magnet and surrounds the outer rim of the target to facilitate sputtering from the target rim, without the need to provide an enlarged magnet structure extending beyond the target outer rim.

In addition, according to a preferred embodiment of the present invention, fixed lumped magnets of different magnetic material are positioned at various points along the magnetic loop so as to selectively influence portions of the magnetic field to provide certain desired field shapes. Particularly, according to certain preferred embodiments of the present invention, the lumped magnets are oriented with one pole toward the target and one away from the target so that the magnetic fields produced by the lumped magnets cooperate with the field provided by the magnetic loop to sharpen the field at various points. Particularly, certain of the lumped magnets are provided opposite the axis of rotation from the point of the loop where the magnet most closely approaches the axis. In this way, a small portion of the magnetic field, which does not otherwise extend across the central portion of the target, is drawn across the center to provide some degree of erosion to, and sputtering from, the central portion of the target. In addition, in accordance with certain embodiments of the present invention, the lumped magnets are provided at the outermost reaches of the loop near the edge of the target to shape the field more precisely in these regions.

In accordance with a further preferred embodiment, the target itself is shaped in a way to cooperate with the sputtering pattern created by the magnetic configuration so as to provide for a maximum utilization of the target material. In this respect, the target is of non-uniform thickness and is, for example, in the illustrated embodiment, more particularly thicker at the outer regions near the outer edge thereof.

In alternative embodiments, particularly where there may be some advantage to varying or adjusting the magnetic field strength, any of the magnets, and particularly the closed loop magnet, may be electromagnets.

Suitably the target is bonded or otherwise secured in intimate heat conducting contact with a target nest. A closed cavity is provided behind the target nest enclosing the rotating magnet. A turbulent layer of water or other cooling fluid is maintained by injecting cooling water into the cavity behind the nest. The fluid is injected into the space near the center of the target assembly near the axis of rotation of the magnet so as to flow through a narrow space between the rotating magnet and the back surface of the target nest. In this space, the cooling fluid is propelled along the back surface of the nest and outwardly by the rotation of the magnet structure, and more particularly by the raised surface of the magnets themselves, so as to provide a turbulent skin of cooling water adjacent the surface of the nest improving the flow of the water and the cooling effect thereof.

These and other objectives and advantages of the present invention will be more readily apparent from the following detailed description of the drawings in which:

### Brief Description of the Drawings

Fig. 1 is a cross-sectional view through a target assembly of one preferred embodiment of an apparatus embodying principles of the present invention.

Fig. 2 is a view taken generally along lines 2-2 of Fig. 1 illustrating the face of the rotatable plate and magnet assembly.

Fig. 3 is a cross-sectional view along lines 3-3 of Fig. 2.

Fig. 4 is a fragmentary cross-sectional view along lines 4-4 of Fig. 2.

Fig. 5 is a view similar to Fig. 2 illustrating an alternative rotating magnet assembly configuration.

Fig. 6 is a set of diagrams A through D illustrating the preferred magnetic pole orientation for the main magnet according to certain features of the present invention.

Fig. 7 is a set of diagrams A through D illustrating a preferred auxiliary magnetic arrangement according to certain features of the present invention.

Fig. 8 is a set of diagrams A and B illustrating a preferred auxiliary magnetic arrangement according to other features of the present invention.

### Detailed Description of Drawings

Magnetron sputtering devices of the type to which the present invention relates are described in the following commonly assigned U.S. patents and copending patent applications.

U.S. Patent Nos. 4,909,695 and 4,915,564 entitled "Method and Apparatus for Handling and Processing Wafer-Like Materials", and,

European Patent Application Nos. 90304044.2 and 90304043.4.

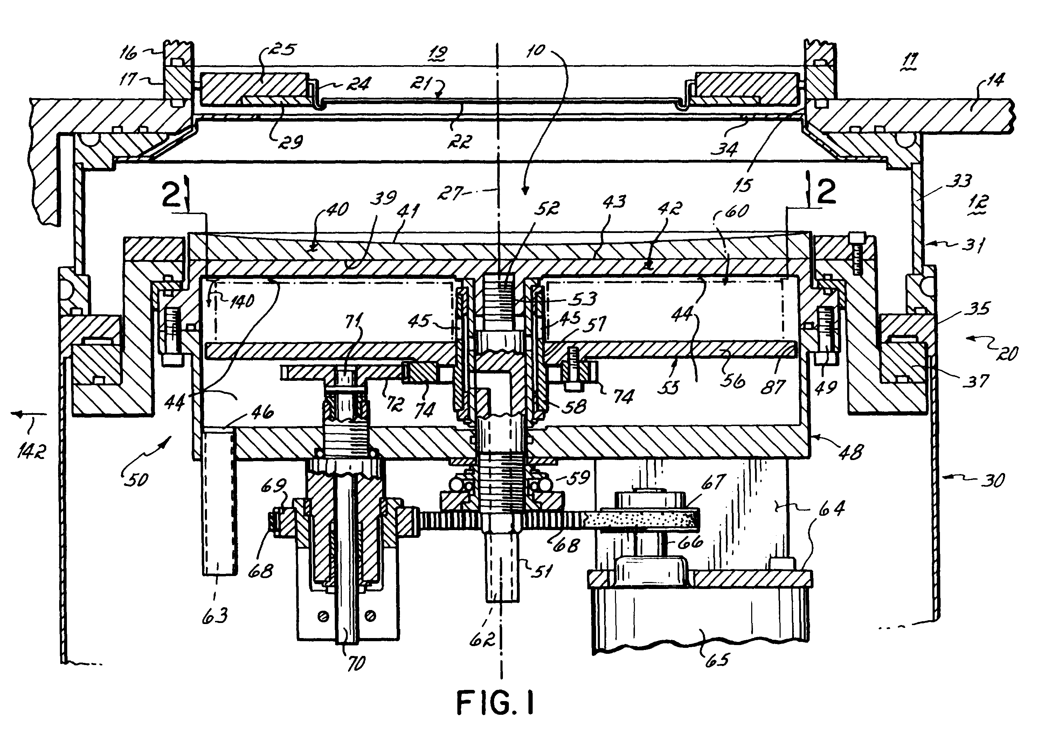

Fig. 1 illustrates, in cross-section, a sputter coating processing chamber 10 of a sputter coating apparatus according to principles of the present invention. The chamber 10 is a portion of the sputter processing apparatus disclosed in U.S. Patent 4,909,695. The processing chamber 10 is a vacuum processing chamber formed of an isolated section of a main chamber 11. The main chamber 11 is isolated from the atmosphere of the machine environment 12 by a plenum wall 14. The processing chamber 10 is capable of communicating with the main chamber 11 throughout opening 15 (shown sealed) in the plenum wall 14.

As more fully described in U.S. Patent 4,909,695, the sealing of the opening 15 isolates the chamber 10 from the main processing chamber 11 by the selective movement of a processing chamber backplane section 16 against a portion of a disk shaped rotary wafer transport member 17 clamping the transport member 17 between the backplane section 16 and the plenum wall 14 in a sealing relationship (as shown), thereby enclosing a backplane space 19 within the processing chamber 10 and isolating the processing chamber 10 from the main chamber 11.

Opposite the backplane section 16, on the front plane side of the transport member 17, the processing chamber 10 is isolated from the machine environment 12 with a cathode assembly module 20 mounted in a vacuum sealing relationship against the plenum wall 14 surround the opening 15. The module 20, or processing chamber frontplane section, cooperates with the backplane section 16 and the transport member 17 to form the sealed isolated processing chamber which is isolated from both the main chamber 11 and the machine external environment 12.

Within the processing chamber 10 is a substrate or workpiece 21 in the form of a flat silicon wafer or disk which has the surface 22 upon which a coating is to be deposited in a sputter coating process to be performed within the processing chamber 10. The wafer 21 is held by a set of clips or other retaining devices 24 in a wafer holder 25 resiliently carried by the transport member 17. The transport member 17 is rotatable within the main chamber to bring the holder 25, and the workpiece or wafer 21 into alignment with the hole 15 so that the processing chamber 10 can be formed around the wafer 21 on the holder 25 by transverse movement of the backplane section 16 to move the member 17 against the plenum wall 14. The transport member portion 17 is a transversely movable ring carried by a rotatable index plate which is not shown, but described more fully in the above-mentioned patents nos. 4,909,675 and 4,915,564.

In this preferred embodiment, the wafer 21 is supported in a plane perpendicular to, and concentric with, a central axis 27 of the main chamber 10, which is also concentric with the hole 15 in the plenum wall 14. Surrounding the wafer 21 on the holder 25 is a disk 29 which at least partially protects the holder 25 from an excessive accumulation of coating intended for but which missed, the surface 22 of the wafer 21. Details of the sputtering apparatus of which the processing chamber 10 is a part including particularly details of the wafer transport 17, wafer holder 25, and backplane section 16, are described and illustrated in U.S. Patent 4,909,695 and 4,915,564 mentioned above.

The cathode assembly module 20 includes two assemblies, a removable cathode assembly 30 and a fixed assembly portion 31. The fixed assembly portion 31 is an annular enclosure rigidly mounted in sealed relationship against the plenum wall 14 surrounding the opening 15. It includes a cylindrical metal side wall 33 of the chamber 10, which is electrically grounded to the frame 14 of the plenum, a wafer holder shield 34 which surrounds the opening 15 and a chamber door frame assembly 35.

The cathode assembly 30 is mounted to a hinged door assembly 37 which removably but sealably supports the cathode assembly 30 to the fixed assembly 31. The cathode assembly 30 carries the sputtering target 40, which is a circular target having a continuous smooth concave sputtering surface 41 and a back surface 39. The assembly 30 supports the target 40 with its axis in alignment with the axis 27 of the chamber 10 and with its sputtering surface 41 facing the surface 22 of the wafer 21 to be coated.

The target 40 is supported in a target nest 42 having a front surface 43 conforming to surface 39 and concentric with axis 27. The back surface 39 of the target 40 is soldered or otherwise bonded to the front surface 43 of the nest 42, in intimate thermal contact therewith. The target back surface 39 is a cooling surface which, when the target 40 is mounted in holder 42, conforms to and lies in close cooling contact with the surface 43 of the holder 42. Behind the nest 42, opposite the cooling surface 43 thereof, is a space 44 for the circulation of cooling liquid, which is generally water, to remove heat generated in the target 40 during sputtering by cooling the heat conductive target holder 42. The cooling fluid is circulated into and out of the space 44 from an inlet port 45 to an outlet port 46 in a magnet assembly 50, as described below. The space 44 is enclosed behind the nest 42 by a housing structure 48 onto which the nest 42 is rigidly supported, and to which it is secured by bolts 49.

The shapes of the surfaces of the target 40 are preferably such that all the target 40 is capable of being formed by turning block of sputtering material on a lathe. The target holder 40 is made of a heat conductive and electrically conductive material, preferably hard tempered OFHC copper or Alloy 110.

The magnet assembly 50 includes a shaft 51 having a threaded end 52 by which the shaft 51 is rigidly mounted in a threaded bore 53 at the center of the back surface of the nest 42. The assembly 50 also includes a rotatable magnet carrier assembly 55 which includes a circular disk 56 of non-magnetic stainless steel or other such material having a central hole 57 therein at which the disk 56 is rigidly mounted to a sleeve assembly 58 rotatably mounted through a bearing assembly 59 through the housing 48 and to the nest 42 to rotate about the shaft 51 on the axis 27. The rotatable magnet assembly further includes a magnet structure 60 rigidly mounted on the disk 56 to rotate therewith. The magnet 60 surrounds the axis 27 and lies beneath or behind the nest 42, opposite the front surface 43 thereof, and close enough thereto to generate a closed magnetic field above the sputtering surface 41 of the target 40 mounted on the surface 43 of the nest 42.

The shaft 51 has a cooling fluid inlet duct 62 extending therethrough which communicates with the inlet port 45 to the interior cooling chamber 44 between the nest 42 and the housing 48. The housing 48 has mounted near the edge thereof a cooling fluid outlet duct 63 which communicates with the fluid outlet port 46 in the cooling space 44.

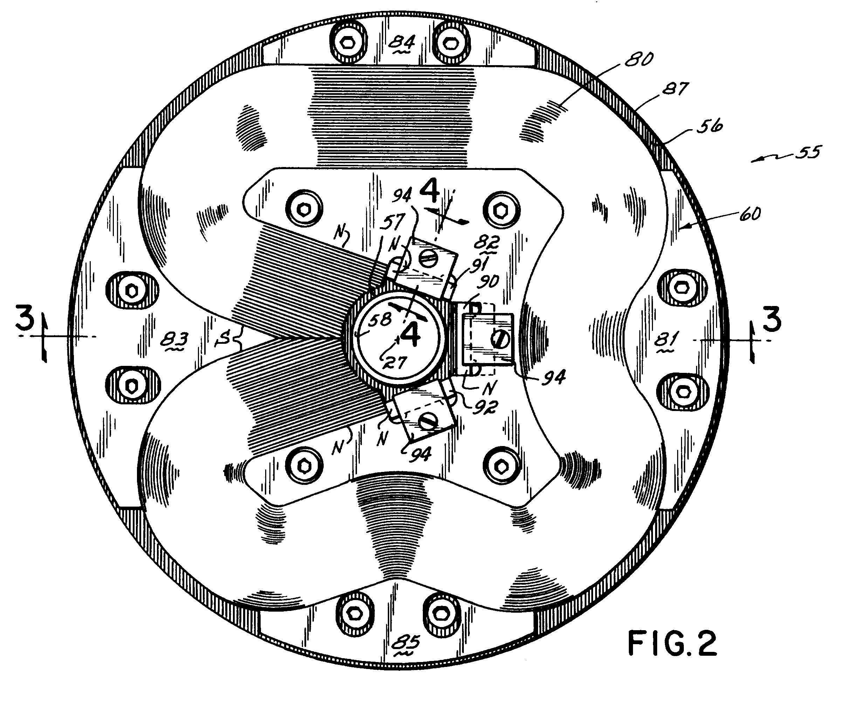

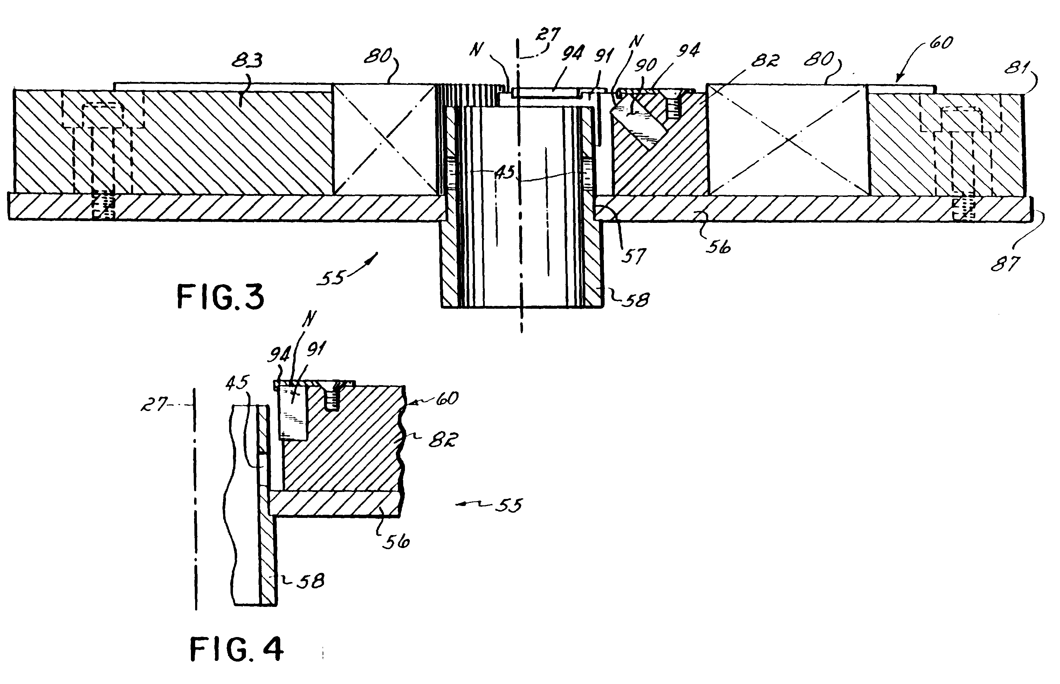

Mounted to the back of the housing 48 is a bracket 64 to which is mounted a magnet rotary drive motor 65. The motor 65 has an output shaft 66 with a cogged drive wheel 67 mounted at the end thereof for driving a cogged drive belt 68. The belt 68 extends around a cogged drive wheel 69 attached to a drive shaft 70 which is rotatably mounted on the housing 48 extending therethrough and having a free end 71 to which is mounted a drive gear 72. The drive gear 72 is positioned within the space 44 where it engages a mating gear 74 attached to the disk 56 of the rotatable magnet assembly 55. Accordingly, the motor 65, when energized, rotates the magnet assembly 55 to rotate the magnet 60 behind the target nest 42 to rotate the magnetic field over the sputtering surface 41 of the target 40. The details of the construction of the magnet structure 60 and its arrangement on the magnet assembly 55 can be better understood by reference to Figs. 2-4.

Referring to Fig. 2, according to one preferred embodiment of the present invention, the magnet structure 60 is shown supported on the disk or plate 56. The magnet structure 60 is a strip of flexible magnet impregnated plastic made up of a laminated plurality of flexible plastic magnetic ribbons 80, for example 24 in number, arranged in a closed irregular loop on the plate 56. The shape of the magnet 80 is selected such that, as the magnet rotates, the strength and duration of the plasma at any given radius of the target will cause sputtering at a predetermined desired average rate necessary to produce a desired coating distribution on the target. The thickness of the target 40 is further varied across the radius of the target to supply material in proportion to the demands of the sputtering distribution.

The ribbon magnet 80 is held in place in a particular predetermined shape surrounding axis 27 by five clamping blocks 81-85. The ribbons of the magnet 80 are polarized in such a way that one pole of the magnet formed thereby faces outwardly toward the outer rim 87 of the disk 56 and toward the clamping blocks 81, 83, 84 and 85, while the other pole faces inwardly toward the clamping block 82. In the particular embodiment illustrated, each of the ribbons has its north pole facing inwardly and its south pole facing outwardly.

Mounted to the clamping block 82 and positioned about the central axis 27 are three permanent magnets 90, 91 and 92 which are held to the block 82 by clamps 94. Each of the magnets 90, 91 and 92 is oriented with its north pole facing in the general direction toward the target nest with its south pole facing generally toward the plate 56. In the particular embodiment illustrated, the north pole of magnet 90 is inclined at an angle of approximately 45 degrees toward the central axis 27 while the magnets 91 and 92 are oriented parallel to the axis 27.

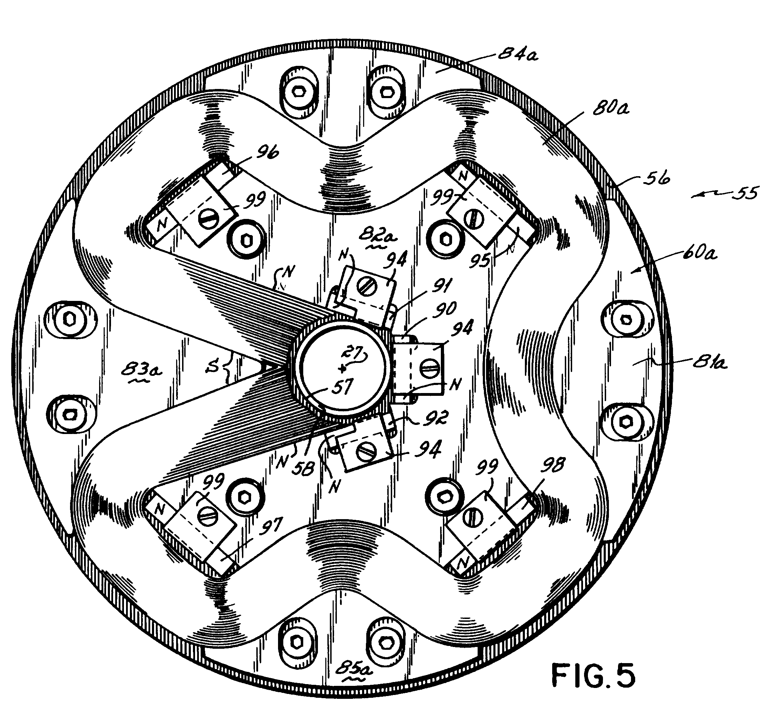

In Fig. 5, an alternative embodiment of magnet structure 60a is illustrated which is differently shaped than the magnet 60 of the embodiment of Fig. 2. The ribbon magnet 80a of the magnet structure 60a is secured to the disk 56 through appropriately shaped clamping blocks 81a-85a. In this embodiment there is also provided additional permanent magnets 95, 96, 97 and 98 clamped to the block 82a by clamps 99 and oriented with their north poles facing towards the target and nest, their south poles toward the plate 56 and their axes generally parallel to the axis 27 of the cathode assembly.

The magnets are arranged on the carrier plate 56 to cause sputtering from the target 40 to be distributed in such a way as to achieve a desired distribution, usually a uniform distribution, of the coating material on the substrate 20. With a generally circular target 40 and circular substrate 20, with a magnet assembly that rotates about the axis 27 through the centers of the target 40 and substrate 20, as in the illustrated embodiments, the relative average sputtering rate will be constant at any given radius from the target center, but may vary with the distance from the axis 27. The variation will be a function of the average intensity of ion bombardment of the target surface at any given radius, which is in turn a function of the average plasma density over the area of the target at that the given radius. This variation will generally be proportional to the portion of a circle at any given radius which is enclosed by the magnetic field. Integrating the plasma density around such circles will yield the approximate relative sputtering from the target surface 41 at the given radius from the target center.

To obtain erosion of all parts of the target, it is necessary that the plasma be present for some portion of the rotation of the magnet assembly over every region of the target. This is desirable even over regions where sputtering of material from the target is not necessary, since the total lack of ion bombardment of the target surface at any point usually results in a redeposition of sputtering material. This most often occurs at the edges and center of the target. The difficulty in producing the magnetic field close to the target edge is due in some circumstances to the undesirability in enlarging the cathode assembly to include a large diameter magnet, particularly with a rotating magnet. With a rotating magnet, the presence of the magnet at the axis of rotation causes excessive sputtering at the center, since the magnet will not rotate through the center of the target.

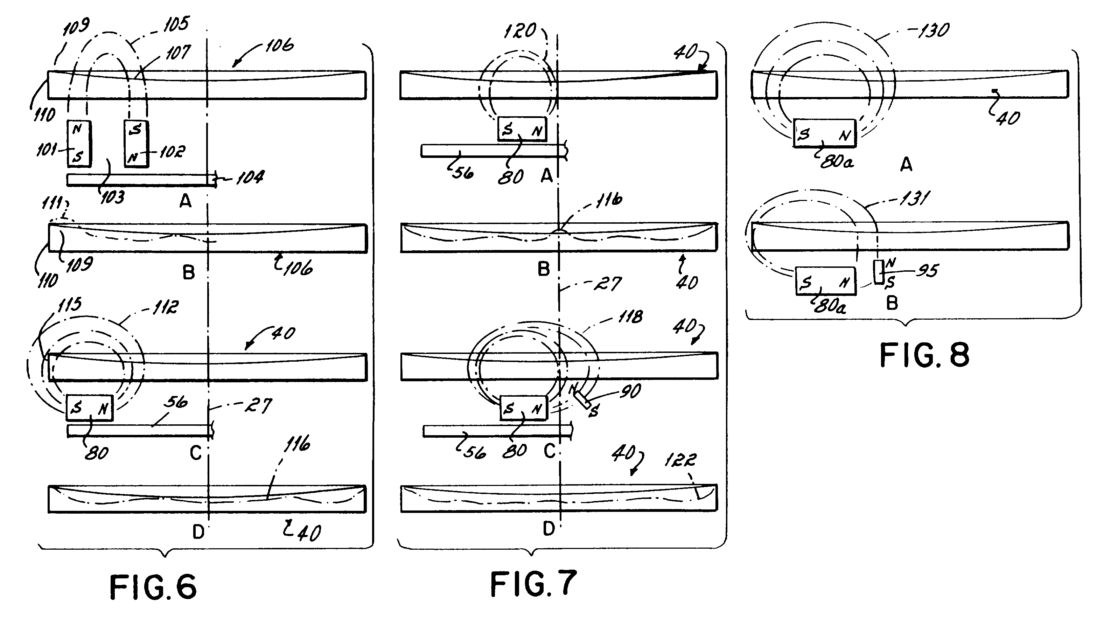

As illustrated in Fig. 6, the properties of one of the features of the present invention is presented in a series of diagrams A through D. In diagram A of Fig. 6, a magnet arrangement is illustrated wherein a pair of magnets 101 and 102 are spaced opposite a gap 103 on a steel carrier 104 to produce a magnetic field 105 over the target 106. The lines of the field 105 generally emerge from the surface 107 of the target 106 approximately perpendicular to the surface and immediately above the magnets 101 and 102. Unless the magnet structure is enlarged with respect to the target 106, this often results in a region 109 adjacent the edge 110 of the target 106 that is too remote from the plasma trapped by the field 105 to receive a bombardment of ions to cause sputtering. As a result, sputtering material may be redeposited on the region 109 of the target 106, as illustrated by the erosion profile 111 in diagram B of Fig. 6.

As illustrated in diagram C of Fig. 6, in accordance with one of the features of the present invention, the magnet 80 is oriented on the carrier plate 56 with the poles spaced parallel to the target so that the field lines 112 emerge from and reenter the magnet 80 with a component which is angled along the radius of the target 40, most importantly in a direction away from the center and encircling the target edge 115. As a result, a portion of the plasma is sufficiently close to the edge to cause enough sputtering from the region near the edge of the target 40 to prevent an accumulation of redeposited sputtered material, and to sputter any additional material from the edge as may be desired. As a result, the eroded profile of the target is in accordance with that shown at 116 in diagram D of Fig. 6.

Producing a desired sputtering rate at the center of the target, according to other features of the present invention, is illustrated in the diagrams of Fig. 7. Referring to diagram A of Fig. 7, the field from the main magnet 80, at its point proximate the center of the target 40, is illustrated in diagram A of Fig. 7. There it is necessary that the field portion 120 be sufficiently spaced from the center axis 27 of the target 40 to prevent excessive erosion and burn-through of the target 40 at the center. As a result, little sputtering occurs at the target center and, accordingly, there is a tendency for sputtered material to redeposit and build up at the target center. The provision of the auxiliary magnets 90, 91 and 92, around the axis 27, with their poles oriented so that their fields combine with that of the magnet 80 to produce a resultant field 118, draws sufficient plasma over the target center to cause the redeposited material at the target center to be resputtered from the target, and, in addition, for any other material of the target at the center to be sputtered, without excessive sputtering to occur at the target center, as illustrated by the erosion profile 122 in diagram D of Fig. 7.

Auxiliary magnets such as the magnets 95-98 in Fig. 5, according to other features of the present invention, cooperate with the main magnet 80a of Fig. 5, to sharpen and reshape the field to redistribute the erosion of the target. As illustrated in diagram A of Fig. 8, the field 130 of the magnet 80a may, for example, cause excessive sputtering along one edge, for example the inner edge, of the magnetic tunnel. By provision of the auxiliary magnet 95, for example, as illustrated in diagram B of Fig. 8, the resultant field 131 is reshaped to better achieve the erosion and sputtering distribution characteristics desired.

The magnets 80 and 80a are dimensioned so as to project a slight distance, approximately 1/32 inch (0.8 mm), into the space 44 between the back of the target nest and the carrier 56, leaving a clearance between the magnet of, for example 1/16 inch (1.6 mm) between the magnet and the nest back and about 3/32 inch (2.4 mm) between the magnet retaining blocks 81-84 and 81a-84a and the nest back. The magnets 80, 80a, because of their serpentine shape, thus turbulently move the cooling water through the space 44 as the magnet assembly 50 rotates. This causes the water or other cooling liquid being used to more effectively remove heat from the nest 42 and to facilitate circulation of the water from the central portion toward the outer portion of the space 44 by a centrifugal pumping action, as shown by the arrow 140 in Fig. 1. With this feature, the apparatus may be oriented with the substrate horizontal, but if in a vertical plane, is preferably with oriented upward direction being the direction of the arrow 142 in Fig. 1, and with the cooling water outlet 63 at the top or high point in the space 44.

## Claims

1. A magnetron sputter coating apparatus for sputter coating a substrate (21) in a pressure sealed chamber (10) comprising a substrate holder (25) , means (42) for supporting a target (40) of sputter coating material with the sputtering surface generally facing the substrate (21), a magnet carrier (55) positioned behind the target (40) opposite the substrate (21) and mounted to rotate with respect to the target (40) and substrate (21) about an axis (27) which intersects the target and substrate, means (65) for rotating the carrier (55) and a main magnet (80, 80a) secured so as to rotate with the carrier (55) and arranged in a closed loop, the main magnet (60) producing a magnetic field (112) which forms a closed magnetic tunnel trapping a plasma thereunder and which rotates over the sputtering surface of the target (40) about the axis (27) as the carrier (55) rotates, characterised in that auxiliary magnetic means (90, 91, 92, 95, 96, 97) distinct from the main magnet (80, 80a) is mounted so as to rotate with the carrier (55) near at least one section of the main magnet (80, 80a) and reshapes the field of the magnet at the section and thereby modifies the position or strength of the plasma on the sputtering surface adjacent thereto, whereby to produce a desired sputtering distribution across the target surface.

2. Apparatus as claimed in Claim 1, wherein the main magnet (60, 60a) comprises a continuous strip (80, 80a) of magnetic material arranged to form the closed loop, the strip (80, 80a) having an inner periphery of one polarity and an outer periphery of the opposite polarity and wherein a plurality of clamping blocks (81-85, 81a-85a) is provided including at least one inner block (82) mounted to the carrier (55) adjacent at least a portion of the inner periphery of the strip (80, 80a) and at least one outer block (81, 83-85) mounted to the carrier (55) adjacent the outer periphery of the strip (80, 80a) to clamp the strip (80, 80a) therebetween, the blocks (81-85, 81-85a) being so shaped and positioned on the carrier (55) as to define the shape and position of the loop on the carrier (55) and so configure the magnet (80, 80a) with respect to the target (40) as to produce a desired sputtering distribution across the target surface.

3. Apparatus as claimed in either Claim 1 or Claim 2, wherein the target (40) is bounded by an outer rim (115) and the loop includes at least one radially outward section moveable with the carrier (55), remote from the axis (27) and underlying the sputtering surface near the rim (115) of the target (40), to produce at least some sputtering of the target surface adjacent the rim, and at least one radially inward section moveable with the carrier (55) underlying the sputtering surface near, but not at, the axis (27).

4. Apparatus as claimed in Claim 3 as dependent on Claim 2, wherein each of the sections is shaped and positioned by the shapes and positions of the clamping blocks (81-85, 81a-85a), and wherein the clamping blocks (82, 82a) at the outer section of the loop are adjacent only the inner periphery.

5. Apparatus as claimed in any preceding Claim, wherein the auxiliary magnetic means (90, 91, 92, 95, 96, 97) is located with respect to the axis (27) so as to reshape the field of the main magnet (80) such that a portion of the plasma extends sufficiently near the sputtering surface proximate the axis (27) so as to cause at least some sputtering from the sputtering surface at the axis (27).

6. Apparatus as claimed in Claim 5, wherein the auxiliary magnetic means (90, 91, 92, 95, 96, 97) is located proximate the or an inward section of the loop whereby to cause at least some sputtering from the sputtering surface at the axis (27).

7. Apparatus as claimed in any preceding Claim, wherein the auxiliary magnetic means includes at least one auxiliary magnet (90, 91, 92, 95, 96, 97) mounted on the carrier (55) to rotate therewith.

8. Apparatus as claimed in Claim 7, wherein the magnet carrier (55) is mounted to rotate with respect to the target (40) and substrate (21) in a plane generally parallel to the substrate (21), wherein the loop (80) has an inner peripheral surface of one polarity and an outer peripheral surface of the opposite polarity such that the polar axes along the loop extend generally across the loop and parallel to the plane, and wherein the auxiliary magnet (90, 91, 92, 95, 96, 97) has a polar axis lying outside of the plane and is located near a portion of a peripheral surface of the loop.

9. Apparatus as claimed in any preceding Claim, wherein the target (40) has a thickness which varies with the distance from the axis (27) so as to provide sputtering material in accordance with a predetermined distribution across the sputtering surface of the target (40) and wherein the main magnet (80, 80a) is so shaped or the field thereof is so reshaped by the auxiliary magnetic means (90, 91, 92, 95, 96, 97) as to affect the intensity and duration of the plasma at different radii from the axis (27) to utilise the sputtering material in accordance with the predetermined distribution across the sputtering surface.

10. Apparatus as claimed in any preceding Claim, further comprising means (50) surrounding the magnet (60) and carrier (55) for containing cooling fluid therein, including a wall (43) maintained in heat transfer relationship with the back (39) of the target (40) and means on the carrier for facilitating the flow of cooling fluid along the wall (43) as the carrier rotates.

11. Apparatus as claimed in any preceding Claim, wherein a back surface (39) of the target (40) is in thermal contact with the target supporting means (42), wherein the carrier (55) has a magnet supporting side generally coextensive with the target supporting means (42) and spaced therefrom to form a narrow gap (44) therebetween and wherein means (80, 80a) is provided on the carrier (55) for pumping cooling fluid through the gap (44) and along the target supporting means (42) as the carrier (55) rotates in response to force applied by the carrier rotating means (65).

12. Apparatus as claimed in either Claim 10 or Claim 11, wherein the main magnet (80, 80a) includes structure projecting from the carrier (55) and the means on the carrier for facilitating or pumping cooling fluid includes the projecting structure of the main magnet (80, 80a).

13. Apparatus as claimed in any preceding Claim, wherein the target supporting means (42) includes a target backing plate (43), wherein the target (40) is surrounded by an outer rim, the target supporting means (42) including means (52) for structurally supporting the backing plate (43) in the vicinity of the target rim and on a central shaft (51) in the vicinity of the axis (27) and wherein the means (59) for rotating the carrier (55) are supported on the shaft (51) and connected to the carrier (55).

14. Apparatus as claimed in any preceding Claim, wherein the main magnet (80, 80a) is a permanent magnet.

15. A method of manufacturing a sputter coated article supported on a holder in a pressure sealed chamber, with a target of sputter coating material having a sputtering surface thereon, the target being supported in the chamber with the sputtering surface generally facing the article to be coated, comprising generating a plasma over the sputtering surface, producing with a main magnet arranged in a closed loop and located behind the target opposite the sputtering surface thereof a magnetic field and forming therewith a closed magnetic tunnel over the sputtering surface of the target and trapping the plasma therewith, and rotating the magnet about an axis that intersects the sputtering surface to move the plasma around the axis and across the sputtering surface of the target by rotating the tunnel thereover and sputter coating the article thereby, characterised in that the method includes providing, adjacent a section of the magnet and also rotating about the axis, auxiliary magnetic means distinct from the main magnet and reshaping with the auxiliary magnetic means at least part of the magnetic field to modify the position or strength of the plasma on the sputtering surface adjacent thereto whereby to produce a desired sputtering distribution across the target surface.

16. A method as claimed in Claim 15, wherein before any sputtering of the target, the target has a thickness which varies with the distance from the axis so as to provide sputtering material in accordance with a predetermined distribution across the sputtering surface of the target, and wherein the method includes reshaping the magnetic field so as to affect the intensity or duration of the plasma at different radii from the axis to utilize the sputtering material in accordance with the predetermined distribution across the sputtering surface upon the rotation of the magnet about the axis, at different radii thereof approximately in accordance with the predetermined distribution.

17. A method as claimed in either Claim 15 or Claim 16, including extending with the auxiliary magnetic means at least part of the field across the axis such that a portion of the plasma is present sufficiently near the sputtering surface adjacent the axis to cause at least some sputtering from the sputtering surface at the axis.

18. A method as claimed in any one of Claims 15 to 17, wherein the auxiliary magnetic means comprises at least one auxiliary magnet mounted for rotation with the main magnet and the method includes rotating the magnets in fixed spaced relation to each other about the axis to move the plasma across the sputtering surface of the target by rotating the tunnel thereover to sputter the target from the axis to its rim.

19. A method as claimed in any one of Claims 15 to 18, further comprising cooling the target by surrounding the magnet with a wall defining a space and containing cooling fluid therein, maintaining part of the wall in heat transfer relationship with the target, providing an irregular surface structure rotatable with the magnet in contact with the cooling fluid, the irregular surface structure being spaced from the wall, opposite the target, and forming a gap therebetween, and, rotatably driving the magnet and surface structure and, with the force exerted thereby, causing flow of cooling fluid through the gap and along the wall.

## Patentansprüche

1. Magnetronsputterbeschichtungsvorrichtung zum Sputterbeschichten eines Substrates (21) in einer druckdichten Kammer (10) mit einem Substrathalter (25), Mitteln (42) zum Stützen eines Targets (40) aus Sputterbeschichtungsmaterial, wobei die Sputteroberfläche im wesentlichen zu dem Substrat (21) gerichtet ist, einem Magnetträger (55), welcher hinter dem Target (40), gegenüber dem Substrat (21) angeordnet ist und angebracht ist, um bezüglich des Targets (40) und des Substrats (21) um eine Achse (27) zu rotieren, welche das Target und das Substrat schneidet, Mitteln (65) zum Rotieren des Trägers (55) und einem Hauptmagnet (80, 80a), welcher so befestigt ist, daß er mit dem Träger (55) rotiert, und welcher in einer geschlossenen Schleife angeordnet ist, wobei der Hauptmagnet (60) ein magnetisches Feld (112) erzeugt, welches einen geschlossenen magnetischen Tunnel bildet, welcher darunter ein Plasma einschließt, und welcher über die Sputteroberfläche des Targets (40) um die Achse (27) rotiert, wenn der Träger (55) rotiert,
dadurch gekennzeichnet, daß beabstandet von dem Hauptmagneten (80, 80a) ein zusätzliches Magnetmittel (90, 91, 92, 95, 96, 97) angebracht ist, um in der Nähe mindestens einer Sektion des Hauptmagneten (80, 80a) mit dem Träger (55) zu rotieren, und welches das Magnetfeld in der Sektion verformt und somit die Position oder Stärke des Plasmas auf der dazu benachbarten Sputteroberfläche modifiziert, um somit eine gewünschte Sputterverteilung über der Targetoberfläche zu erzeugen.

2. Vorrichtung nach Anspruch 1,
dadurch gekennzeichnet, daß der Hauptmagnet (60, 60a) einen kontinuierlichen Streifen (80, 80a) aus magnetischem Material enthält, welcher so angeordnet ist, daß er eine geschlossene Schleife bildet, wobei der Streifen (80, 80a) eine innere Peripherie einer Polarität und eine äußere Peripherie der entgegensetzten Polarität aufweist, und wobei eine Vielzahl von Klemmblöcken (81-85, 81a-85a) vorgesehen ist, einschließlich mindestens eines inneren Blocks (82), welcher an dem Träger (55) benachbart zu mindestens einem Abschnitt der inneren Peripherie des Streifens (80, 80a) angebracht ist, und mindestens eines äußeren Blocks (81, 83-85), welcher benachbart zu der äußeren Peripherie des Streifens (80, 80a) an dem Träger (55) angebracht ist, um den Streifen (80, 80a) dazwischen festzuklammern, wobei die Blöcke (81-85, 81-85a) derart geformt und auf dem Träger (55) angeordnet sind, um die Form und die Position der Schleife auf dem Träger (55) zu definieren und somit den Magnet (80, 80a) mit Bezug auf das Target (40) zu konfigurieren, um über der Targetoberfläche eine gewünschte Sputterverteilung zu erzeugen.

3. Vorrichtung nach einem der Ansprüche 1 oder 2,
dadurch gekennzeichnet, daß das Target (40) durch eine äußere Einfassung (115) gehaltert ist und die Schleife mindestens ein sich radial nach außen erstreckende Sektion aufweist, welche mit dem Träger (55) bewegbar ist, und welche von der Achse (27) entfernt ist, und welche unter der Sputteroberfläche in der Nähe der Einfassung (115) des Targets (40) liegt, um mindestens etwas Sputtern der Target-oberfläche benachbart zu der Einfassung zu erzeugen, und mindestens einer radial nach innen gerichteten Sektion, welche mit dem Träger (55) beweglich ist, und welche unter der Sputteroberfläche in der Nähe aber nicht auf der Achse (27) liegt.

4. Vorrichtung nach den Ansprüchen 2 und 3,
dadurch gekennzeichnet, daß jede der Sektionen durch die Formen und Positionen der Klemmblöcke (81-85, 81a-85a) geformt und positioniert wird, und wobei die Klemmblöcke (82, 82a) in der äußeren Sektion der Schleife nur zu der inneren Peripherie benachbart sind.

5. Vorrichtung nach einem der vorstehenden Ansprüche,
dadurch gekennzeichnet, daß das zusätzliche Magnetmittel (90, 91, 92, 95, 96, 97) bezüglich der Achse (27) derart angeordnet ist, daß es das Feld des Hauptmagneten (80) verformt, so daß ein Abschnitt des Plasmas sich ausreichend in die Nähe der benachbart zu der Achse (27) liegenden Sputteroberfläche erstreckt, um somit mindestens etwas Sputtern von der Sputteroberfläche an der Achse (27) zu verursachen.

6. Vorrichtung nach Anspruch 5,
dadurch gekennzeichnet, daß das zusätzliche Magnetmittel (90, 91, 92, 95, 96, 97) in der Nähe der oder einer nach innen gerichteten Sektion der Schleife angeordnet ist, um somit mindestens etwas Sputtern von der Sputteroberfläche an der Achse (27) zu verursachen.

7. Vorrichtung nach einem der vorstehenden Ansprüche,
dadurch gekennzeichnet, daß das zusätzliche Magnetmittel mindestens einen zusätzlichen Magneten (90, 91, 92, 95, 96, 97) einschließt, welcher auf dem Träger (55) angebracht ist, um mit diesem zu rotieren.

8. Vorrichtung nach Anspruch 7,
dadurch gekennzeichnet, daß der Magnetträger (55) derart angebracht ist, daß er bezüglich des Targets (40) und des Substrates (21) in einer im wesentlichen zu dem Substrat (21) parallelen Ebene rotiert, wobei die Schleife (80) eine innere periphere Oberfläche einer Polarität und eine äußere periphere Oberfläche der entgegengesetzten Polarität aufweist, so daß die Polarachsen entlang der Schleife sich im wesentlichen quer zu der Schleife und parallel zu der Ebene erstrecken, und wobei der zusätzliche Magnet (90, 91, 92, 95, 96, 97) eine Polarachse aufweist, welche außerhalb der Ebene und in der Nähe eines Abschnittes einer peripheren Oberfläche der Schleife liegt.

9. Vorrichtung nach einem der vorstehenden Ansprüche,
dadurch gekennzeichnet, daß das Target (40) eine Dicke aufweist, welche mit dem Abstand von der Achse (27) variiert, um somit Sputtermaterial in Übereinstimmung mit einer vorbestimmten Verteilung über der Sputteroberfläche des Targets (40) zur Verfügung zu stellen, und wobei der Hauptmagnet (80, 80a) derart geformt ist, oder wobei das Feld desselben derart durch das zusätzliche Magnetmittel (90, 91, 92, 95, 96, 97) verformt ist, daß die Intensität und die Dauer des Plasmas in verschiedenen Radien von der Achse (27) beeinflußt wird, um das Sputtermaterial in Übereinstimmung mit der vorbestimmten Verteilung über der Sputteroberfläche zu verwenden.

10. Vorrichtung nach einem der vorstehenden Ansprüche,
gekennzeichnet durch Mittel (50), welche den Magneten (60) und den Träger (55) umgeben, um in diesen Kühlflüssigkeit aufzubewahren, einschließlich einer Wand (43), welche in hitzeübertragender Beziehung mit der Rückseite (39) des Targets (40) gehalten wird, und Mitteln auf dem Träger zur Vereinfachung des Flusses der Kühlflüssigkeit entlang der Wand (43), wenn der Träger rotiert.

11. Vorichtung nach einem der vorstehenden Ansprüche,
dadurch gekennzeichnet, daß eine rückseitige Oberfläche (39) des Targets (40) sich in thermischem Kontakt mit dem Targetträgermittel (42) befindet, wobei der Träger (55) eine Magnetträgerseite aufweist, welche sich im wesentlichen zusammen mit dem Targetträgermittel (42) erstreckt und von diesem beabstandet ist, um eine schmale Lücke (44) dazwischen zu bilden, und wobei ein Mittel (80, 80a) auf dem Träger (55) vorgesehen ist, um die Kühlflüssigkeit durch die Lücke (44) und entlang des Targetträgermittels (42) zu pumpen, wenn der Träger (55) in Reaktion auf eine durch das Trägerrotationsmittel (65) angelegte Kraft rotiert.

12. Vorrichtung nach einem der Ansprüche 10 oder 11,
dadurch gekennzeichnet, daß der Hauptmagnet (80, 80a) eine Struktur aufweist, die sich von dem Träger (55) erstreckt, und daß das Mittel auf dem Träger zum Erleichtern des Pumpens von Kühlflüssigkeit die sich erstreckende Struktur des Hauptmagneten (80, 80a) einschließt.

13. Vorrichtung nach einem der vorstehenden Ansprüche,
dadurch gekennzeichnet, daß das Targetträgermittel (42) eine Targetgrundplatte (43) einschließt, und daß das Target (40) durch eine äußere Einfassung umgeben ist, und daß das Targetträgermittel (42) ein Mittel (52) zum strukturellen Unterstützen der Grundplatte (43) in der Umgebung der Targeteinfassung und auf einem zentralen Schaft (51) in der Umgebung der Achse (27) einschließt, und wobei die Mittel (59) zum Rotieren des Trägers (55) auf dem Schaft (51) unterstützt und mit dem Träger (55) verbunden sind.

14. Vorrichtung nach einem der vorstehenden Ansprüche,
dadurch gekennzeichnet, daßder Hauptmagnet (80, 80a) ein Permanentmagnet ist.

15. Verfahren zur Herstellung eines sputterbeschichteten Gegenstandes, welcher von einem Halter in einer druckdichten Kammer getragen wird, mit einem Target aus Sputterbeschichtungsmaterial mit einer sich darauf befindenden Sputteroberfläche, wobei das Target in der Kammer so gehaltert ist, daß die Sputteroberfläche im wesentlich dem zu beschichtenden Gegenstand zugewandt ist, wobei ein Plasma über der Sputteroberfläche erzeugt wird, ein magnetisches Feld mit einem Hauptmagneten erzeugt wird, welcher in einer geschlossenen Schleife ausgebildet und hinter dem Target gegenüber der Sputteroberfläche desselben angeordnet ist, und wobei damit ein geschlossener magnetischer Tunnel über der Sputteroberfläche des Targets gebildet wird und das Plasma damit eingeschlossen wird, und wobei der Magnet um eine Achse rotiert wird, welche die Sputteroberfläche schneidet, um das Plasma um die Achse und über die Sputteroberfläche des Targets durch Rotation des darüber liegenden Tunnels zu bewegen und dadurch den Gegenstand sputterzubeschichten,
dadurch gekennzeichnet, daß das Verfahren einschließt, daß, benachbart zu einer Sektion des Magneten und ebenfalls um die Achse rotierend, zusätzliche Magnetmittel zur Verfügung gestellt werden, welche von dem Hauptmagneten beabstandet sind, und wobei mit Hilfe der zusätzlichen Magnetmittel mindestens ein Teil des magnetischen Feldes verformt wird, um die Position oder Stärke des Plasmas auf der dazu benachbarten Sputteroberfläche zu modifizieren, um somit über der Targetoberfläche eine gewünschte Sputterverteilung zu erzeugen.

16. Verfahren nach Anspruch 15,
dadurch gekennzeichnet, daß vor jeglichem Sputtern des Targets das Target eine Dicke aufweist, welche mit dem Abstand von der Achse variiert, um somit Sputtermaterial zur Verfügung zu stellen, in Übereinstimmung mit einer vorbestimmten Verteilung über der Sputteroberfläche des Targets, und wobei das Verfahren einschließt, das magnetische Feld so zu verformen, daß die Intensität oder Dauer des Plasmas in verschiedenen Abständen bezüglich der Achse beeinflußt wird, um das Sputtermaterial in Übereinstimmung mit der vorbestimmten Verteilung über der Sputteroberfläche bei Rotation des Magneten um die Achse, bei verschiedenen Abständen zu derselben, etwa in Übereinstimmung mit der vorbestimmten Verteilung zu verwenden.

17. Verfahren nach einem der Ansprüche 15 oder 16,
dadurch gekennzeichnet, daß mit Hilfe der zusätzlichen Magnetmittel mindestens ein Teil des über der Achse liegenden Feldes verlängert wird, so daß ein Abschnitt des Plasmas sich ausreichend in der Nähe der benachbart zu der Achse liegenden Sputteroberfläche befindet, um mindestens etwas Sputtern von der Sputteroberfläche an der Achse zu verursachen.

18. Verfahren nach einem der Ansprüche 15 bis 17,
dadurch gekennzeichnet, daß das zusätzliche Magnetmittel mindestens einen zusätzlichen Magneten aufweist, welcher angebracht ist, um mit dem Hauptmagneten zu rotieren, und wobei das Verfahren einschließt, die Magneten in fester beabstandeter Beziehung zueinander um die Achse zu rotieren, um das Plasma über der Sputteroberfläche des Targets durch Rotation des Tunnels über diesem zu bewegen, um das Target von seiner Achse bis zu seiner Einfassung zu sputtern.

19. Verfahren nach einem der Ansprüche 15 bis 18,
dadurch gekennzeichnet, daß das Target durch Umgeben des Magneten mit einer Wand, welche einen Raum definiert und darin Kühlflüssigkeit enthält, gekühlt wird, wobei ein Teil der Wand in hitzeübertragender Beziehung mit dem Target gehalten wird, daß eine irreguläre, mit dem Magnet in Kontakt mit der Kühlflüssigkeit rotierbare Oberflächenstruktur zur Verfügung gestellt wird, wobei die irreguläre Oberflächenstruktur beabstandet von der Wand ist, dem Target gegenüberliegt und eine Lücke dazwischen bildet, und daß der Magnet und die Oberflächenstruktur rotierend angetrieben werden und durch die dadurch ausgeübte Kraft ein Fluß der Kühlflüssigkeit durch die Lücke und entlang der Wand verursacht wird.

## Revendications

1. Dispositif à magnétron pour recouvrir par pulvérisation cathodique un substrat (12) placé dans une chambre de pression fermée hermétiquement (10) comprenant un support de substrat (25), un moyen (42) pour maintenir la cible (40) en matériau de revêtement de manière à ce que sa surface de pulvérisation se trouve généralement face au substrat (21), un porteur d'aimant (55) placé sous la cible (40) à l'opposé du substrat (21) et monté de manière à pouvoir tourner par rapport à cette cible et ce substrat autour d'un axe (27) les rencontrant, un moyen (65) pour faire tourner le porteur (55) et un aimant principal (80, 80a) fixé de manière à tourner avec ce porteur et conçu en boucle fermée, l'aimant principal (60) produisant un champ magnétique (112) formant un tunnel magnétique fermé piégeant le plasma situé en dessous et tournant au dessus de la surface de pulvérisation de la cible (40) autour de l'axe (27) lorsque le porteur (55) est en rotation, caractérisé en ce que des moyens magnétiques auxiliaires (90, 91, 92, 95, 96, 97) distincts de l'aimant principal (80, 80a) sont disposés de manière à pouvoir tourner avec le porteur (55) à proximité d'au moins une partie de l'aimant principal (80, 80a) et donner une nouvelle forme au champ de l'aimant au niveau de cette partie, permettant ainsi de modifier la position ou la force du plasma sur la surface de pulvérisation qui lui est adjacente et de produire la distribution souhaitée de la pulvérisation au travers de la surface de la cible.

2. Dispositif selon la revendication 1, dans lequel
- l'aimant principal (60, 60a) comprend une bande continue (80, 80a) de matériau magnétique conçue de manière à former une boucle fermée, la périphérie interne de cette bande ayant une polarité et sa périphérie externe ayant la polarité opposée et
- une pluralité de blocs de verrouillage (81-85, 81a-85a) est mise en place celle-ci comprenant au moins un bloc interne (82) monté sur le porteur (55) à côté d'au moins une partie de la périphérie interne de la bande (80, 80a) et au moins un bloc externe (81, 83-85) monté sur le porteur (55) à côté de la périphérie externe de la bande (80, 80a) de manière à immobiliser cette bande entre ces blocs, les blocs (81-85, 81a-85a) ayant une forme telle et étant positionnés de telle manière sur le porteur (55) qu'ils définissent la forme et la position de la boucle sur ce dernier et donnent ainsi la même forme à l'aimant (80, 80a) par rapport à la cible (40) et qu'ils permettent d'obtenir la distribution souhaitée de la pulvérisation au travers de la surface de cette cible.

3. Dispositif selon la revendication 1 ou la revendication 2, dans lequel la cible (40) est limitée par un rebord externe (115) et la boucle comprend au moins une partie située à distance de l'axe (27) et sous-jacente à la surface de pulvérisation proche du rebord (115), susceptible d'être déplacée avec le porteur (55) radialement vers l'extérieur, destinée à produire au moins une certaine pulvérisation de la surface de la cible adjacente au rebord et au moins une partie sous-jacente à la surface de pulvérisation, située près, mais pas sur, l'axe (27), susceptible d'être déplacée avec le porteur (55) radialement vers l'intérieur.

4. Dispositif selon la revendication 3 lorsqu'elle dépend de la revendication 2, dans lequel la forme et le positionnement de chacune des parties sont définis par les formes et les positions des blocs de verrouillage (81-85, 81a-85a) et dans lequel les blocs (82, 82a) externes à la boucle ne sont adjacents qu'à la périphérie interne.

5. Dispositif selon l'une quelconque des revendications précédentes, dans lequel les moyen magnétiques auxiliaires (90, 91, 92, 95, 96, 97) sont positionnés par rapport à l'axe (27) de manière à donner une nouvelle forme au champ de l'aimant principal (80) de telle sorte qu'une partie du plasma s'approche suffisamment de la surface de pulvérisation à proximité de l'axe (27) pour provoquer au moins une certaine pulvérisation de la surface située au niveau de cet axe.

6. Dispositif selon la revendication 5, dans lequel les moyens magnétiques auxiliaires (90, 91, 92, 95, 96, 97) sont positionnés à proximité de la ou d'une partie interne de la boucle, provoquant ainsi une pulvérisation de la surface située au niveau de l'axe (27).

7. Dispositif selon l'une quelconque des revendications précédentes, dans lequel les moyens magnétiques auxiliaires comprennent au moins un aimant auxiliaire (90, 91, 92, 95, 96, 97) placé sur le porteur (55) pour tourner avec lui.

8. Dispositif selon la revendication 7, dans lequel
- le porteur d'aimant (55) est placé de manière à pouvoir tourner par rapport à la cible (40) et au substrat (21) dans un plan généralement parallèle à ce dernier,
- la boucle (80) possède une face périphérique interne ayant une polarité et une face périphérique externe de polarité opposée de telle sorte que les axes polaires le long de cette boucle la traversent, généralement parallèlement à son plan et
- l'aimant auxiliaire (90, 91, 92, 95, 96, 97) possède un axe polaire se trouvant à l'extérieur du plan et près d'une partie de la surface périphérique de la boucle.

9. Dispositif selon l'une quelconque des revendications précédentes, dans lequel
- l'épaisseur de la cible (40) varie en fonction de sa distance avec l'axe (27) de manière à fournir un matériau de pulvérisation adapté à la répartition prédéterminée au travers de la surface de la cible (40) et
- la forme de l'aimant principal (80, 80a) ou bien la remise en forme de son champ par les éléments magnétiques auxiliaires (90, 91, 92, 95, 96, 97) est définie de manière à jouer sur l'intensité et la durée du plasma en fonction des rayons avec l'axe (27) afin d'utiliser le matériau de pulvérisation selon la répartition prédéterminée au travers de la surface de pulvérisation.

10. Dispositif selon l'une quelconque des revendications précédentes, comprenant en outre un moyen (50) entourant l'aimant (60) et le porteur (55) destiné à contenir un liquide de refroidissement, ce moyen comportant une paroi (43) maintenue en relation avec l'arrière (39) de la cible (40) de manière à assurer un transfert de chaleur avec celui-ci et des moyens sur le porteur pour faciliter l'écoulement du liquide de refroidissement le long de cette paroi lorsque ce porteur tourne.

11. Dispositif selon l'une quelconque des revendications précédentes, dans lequel
- la face arrière (39) de la cible (40) est en contact thermique avec le moyen (42) la portant,
- le porteur (55) possède un côté maintenant l'aimant ayant généralement la même taille que le support de cible (42) et en étant espacé de manière à former un passage étroit (44) entre eux dans lequel le moyen (80, 80a) est mis en place sur le porteur (55) pour pomper le liquide de refroidissement à travers ce passage et le long du support de cible (42) lorsque le porteur (55) tourne après qu'une force ait été appliquée par le moyen le faisant tourner.

12. Dispositif selon la revendication 10 ou la revendication 11, dans lequel l'aimant principal (80, 80a) comprend une structure partant du porteur (55) et le moyen placé sur le porteur destiné à faciliter l'aspiration du liquide de refroidissement ou à le pomper comprend cette structure.

13. Dispositif selon l'une quelconque des revendications précédentes, dans lequel
- le moyen portant la cible (42) comprend une plaque d'appui de celle-ci (43),
- la cible (40) est entourée d'un rebord externe, le support de cible (42) comportant un moyen (52) destiné à maintenir structurellement la plaque d'appui (43) à proximité du rebord de la cible et sur une tige centrale (51) située à proximité de l'axe (27) et
- les moyens (59) destinés à faire tourner le porteur (55) sont portés par cette tige et reliés au porteur (55).

14. Dispositif selon l'une quelconque des revendications précédentes, dans lequel l'aimant principal (80, 80a) est un aimant permanent.

15. Procédé de fabrication d'un produit recouvert par pulvérisation cathodique maintenu sur un porteur dans une chambre de pression fermée hermétiquement, une cible en matériau de revêtement par pulvérisation se trouvant sur ce porteur, cette cible étant maintenue dans la chambre de manière à présenter généralement sa surface de pulvérisation face au produit à recouvrir, comprenant les étapes consistant à :
- générer un plasma sur la surface de pulvérisation,
- produire un champ magnétique avec un aimant principal conçu en boucle fermée et situé sous la cible à l'opposé de sa surface de pulvérisation, former avec ce champ un tunnel magnétique fermé situé au dessus de la surface de pulvérisation de la cible et piéger le plasma avec ce tunnel et
- faire tourner l'aimant autour d'un axe rencontrant la surface de pulvérisation de manière à déplacer le plasma autour de cet axe et au travers de la surface de pulvérisation de la cible grâce au tunnel se trouvant au dessus pour recouvrir ainsi le produit par pulvérisation,
caractérisé en ce que le procédé comporte
. la mise en place, à côté d'une partie de l'aimant, de moyens magnétiques auxiliaires tournant aussi autour de l'axe, distincts de l'aimant principal et
. la remise en forme d'au moins une partie du champ magnétique par ces moyens auxiliaires pour modifier la position ou la force du plasma sur la surface de pulvérisation adjacente à cette partie du champ afin de produire une répartition souhaitée de la pulvérisation au travers de la surface de la cible.

16. Procédé selon la revendication 15, dans lequel, avant toute pulvérisation de la cible, on fait varier son épaisseur en fonction de la distance la séparant de l'axe de manière à fournir un matériau de pulvérisation adapté à une répartition prédéterminée au travers de la surface de pulvérisation et dans lequel le procédé comprend la remise en forme du champ magnétique de manière à jouer sur l'intensité ou la durée du plasma en fonctions des rayons partant de l'axe de manière à utiliser le matériau de pulvérisation selon une répartition prédéterminée au travers de la surface de pulvérisation après la rotation de l'aimant autour de l'axe, celui-ci se trouvant à une distance variable de cet aimant, approximativement fonction de la distribution souhaitée.

17. Procédé selon la revendication 15 ou la revendication 16, comprenant l'extension avec des moyens magnétiques auxiliaires d'au moins une partie du champ au travers de l'axe de telle sorte qu'une partie du plasma se trouve suffisamment près de la surface de pulvérisation adjacente à cet axe pour provoquer au moins une certaine pulvérisation de la surface située au niveau de l'axe.

18. Procédé selon l'une quelconque des revendications 15 à 17, dans lequel les moyens magnétiques auxiliaires comprennent au moins un aimant monté de manière à pouvoir tourner avec l'aimant principal, le procédé comprenant la rotation autour d'un axe des aimants placés à distance déterminée les uns des autres afin de déplacer le plasma au travers de la surface de pulvérisation de la cible par rotation du tunnel se trouvant au dessus de manière à assurer la pulvérisation de la cible de l'axe vers son rebord.

19. Procédé selon l'une quelconque des revendications 15 à 18, comprenant en outre le refroidissement de la cible en
- entourant l'aimant d'une paroi définissant un espace contenant un liquide de refroidissement,
- maintenant le transfert de chaleur entre la paroi et la cible,
- mettant en place au contact du liquide de refroidissement une structure à surface irrégulière susceptible de tourner avec l'aimant, cette structure espacée de la paroi, à l'opposé de la cible, formant un passage entre eux, et
- faire tourner l'aimant et la structure et, avec la force exercer par ceux-ci, provoquer l'écoulement du liquide de refroidissement au travers du passage et le long de la paroi.
